**Europäisches Patentamt**

**European Patent Office**

**Office européen des brevets**

(19)

(11) Veröffentlichungsnummer: **0 095 758**
**A1**

(12) # EUROPÄISCHE PATENTANMELDUNG

(21) Anmeldenummer: **83105285.7**

(22) Anmeldetag: **27.05.83**

(51) Int. Cl.³: **H 03 F 1/32**

(30) Priorität: **28.05.82 DE 3220252**

(43) Veröffentlichungstag der Anmeldung: **07.12.83**
**Patentblatt 83/49**

(84) Benannte Vertragsstaaten: **BE DE IT NL SE**

(71) Anmelder: **SIEMENS AKTIENGESELLSCHAFT, Berlin und München Wittelsbacherplatz 2, D-8000 München 2 (DE)**

(72) Erfinder: **Heynisch, Hinrich, Dr. rer.nat.,Dipl.-Phys., Im Birket 7, D-8032 Gräfelfing (DE)**

(54) **Verfahren zur Beseitigung von Verzerrungen in Verstärkern.**

(57) Um die Leistung und den Wirkungsgrad zu erhöhen und Redundanz zu erhalten, sind zwei Mikrowellenverstärker (1, 2) parallel geschaltet. Dem Verstärker (1) wird eine Eingangsleistung (EL) und dem Laufzeitausgleichelement (3) die doppelte Eingangsleistung zugeführt. Der Verstärker (1) gibt die Ausgangsleistung (AL) mit Verzerrungen ab. Ein Teil der Ausgangsleistung wird über den Richtungskoppler (4) ausgekoppelt und über ein Phasenschieberelement (5) sowie ein Dämpfungselement (6) und die leitende Diode (7) dem aus Laufzeitausgleichelement (3) und Hilfsverstärker (8) bestehenden Zweig amplitudengleich, aber gegenphasig zugeführt. Im Verstärker (8) werden die Verzerrungen verstärkt und im Sinne einer Kompensation dem Ausgangskreis zugeführt. Dem Koppelzweig des Parallelzweiges mit dem zweiten Verstärker (2) wird etwas Leistung entnommen und der Diode (7) zugeführt. Dadurch ist der Koppelzweig vom Verstärker (1) gesperrt, so lange wie der Parallelzweig mit Verstärker (2) in Betrieb ist.

0095758

SIEMENS AKTIENGESELLSCHAFT       Unser Zeichen

Berlin und München              VPA   **82 P 1 4 3 1 E**

**Verfahren zur Beseitigung von Verzerrungen in Verstärkern.**

Die Erfindung bezieht sich auf ein Verfahren nach dem Oberbegriff des Patentanspruchs 1.

Ein derartiges Verfahren ist aus der DE-PS 1 085 194 bekannt.

Bei dem bekannten Verfahren wird erstens eine derartige Differenzspannung gebildet, daß dadurch keine Rückwirkung vom Ausgang des ersten Verstärkers auf seinen Eingang auftritt, zweitens die Ausgangsspannungen der beiden Verstärker derartig zusammengeführt, daß bei der Kompensation der Verzerrungen die Ausgangsspannung des zweiten Verstärkers gegen das die Differenzspannung erzeugende Glied durch Brückenschaltungen oder Richtkoppler entkoppelt ist und drittens wird die Wirkung der Laufzeiten in beiden Verstärkern durch je ein Laufzeitglied aufgehoben.

Der vorliegenden Erfindung liegt die Aufgabe zugrunde, ein Verfahren zur Linearisierung der Übertragungseigenschaften von Verstärkern, insbesondere von Mikrowellenverstärkern in Parallelbetrieb zu schaffen zwecks Redundanz und Leistungserhöhung, d.h. Verbesserung des Betriebswirkungsgrades.

Diese Aufgabe wird erfindungsgemäß durch die im kennzeichnenden Teil des Anspruchs 1 aufgeführten Maßnahmen gelöst.

Spezielle Ausgestaltungen der Erfindung ergeben sich aus den Ansprüchen 2 und 3.

Vorteil der Erfindung ist es, bei einer Redundanzschaltung (Parallelbetrieb) von zwei Verstärkern und der An-Rb 1 Lk/28.5.1982

wendung der sogenannten Vorwärtskompensation zwecks extremer, breitbandiger Linearisierung der beiden Hauptverstärker mit nur einem einzigen Hilfsverstärker auszukommen.
So kann man große Ausgangsleistung mit Redundanz bei hoher Phasen- und Amplitudenlinearität mit bestmöglichem Betriebs-Wirkungsgrad erzielen. Es wird eine Verbesserung des Differenzfaktors 3. Ordnung ($D_{32}$) um 30dB und mehr erreicht, und zwar mit relativ großer Bandbreite, was bei Rückkopplungsentzerrungsschaltungen z.B. nicht erzielt werden kann.

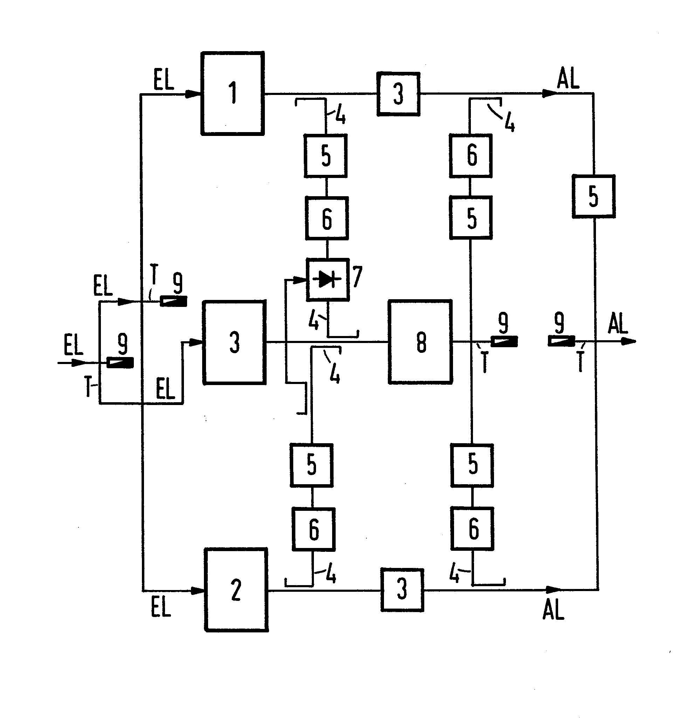

In der Figur der Zeichnung ist eine Schaltungsanordnung zur Durchführung des erfindungsgemäßen Verfahrens dargestellt.

Dem Verstärker 1 wird die Eingangsleistung EL zugeführt. Dem Laufzeitausgleichselement 3 wird die doppelte Eingangsleistung EL zugeführt. Der Verstärker 1 gibt die Ausgangsleistung AL mit Verzerrungen ab. Ein Teil wird ausgekoppelt, beispielsweise über 20dB-Koppler und über ein Phasenschieberelement sowie ein Dämpfungselement dem aus Laufzeitausgleichselement 3 und Hilfsverstärker 8 bestehenden Zweig amplitudengleich, aber gegenphasig zugeführt. Dadurch wird der unverzerrte Grundsignalanteil durch Interferenz ausgelöscht. Es verbleibt die Verzerrungsleistung allein. Sie wird im Hilfsverstärker 8 (weil sehr kleines Signal) praktisch unverzerrt verstärkt und in Gegenphase bei gleicher Amplitude wie der Verzerrungsanteil im Ausgangszweig vom Verstärker 1 diesem wieder zugeführt und löscht hier wiederum durch Interferenz den Verzerrungsanteil aus. Das praktisch unverzerrte Signal wird als Ausgangsleistung AL dem Ausgangszweig zugeführt.

Der Parallelzweig mit dem Verstärker 2 arbeitet praktisch identisch. Hier wird jedoch dem Koppelzweig etwas Leistung entnommen. Sie dient zur Sperrung des Koppelzweiges vom Verstärker 1, beispielsweise mittels einer Sperr- diode 7. Auch hier wird die Verzerrung kompensiert und
die Ausgangsleistung AL dem Ausgangszweig zugeführt.
Beide Ausgangszweige ergeben die doppelte Ausgangsleistung.

Fällt nun der Verstärker 1 oder der Verstärker 2 aus, so
läuft der jeweils andere Verstärker weiter und ergibt im
Ausgangszweig immerhin noch die halbe Ausgangsleistung.

Der Abgleich des Gesamtsystems wird folgendermaßen vorgenommen:
Erstens wird der Verstärker 1 abgeschaltet. Der Verstärker 2 wird durch den Hilfsverstärker 8, wie bereits beschrieben, kompensiert mittels Phasenschieber 5 und Dämpfungsglied 6 bei eingestellter Ausgangsleistung EL. (Messung von $D_{32}$ als Kriterium).
Zweitens wird nun der Verstärker 2 abgeschaltet. Der Verstärker 1 wird mittels Phasenschieber 5 und Dämpfungsglied 6 identisch kompensiert, und zwar bei für beide
Zweige gleich eingestellter Ausgangsleistung AL.
Drittens werden beide Verstärker 1 und 2 eingeschaltet
und zur zweifachen Ausgangsleistung AL durch den im Ausgangszweig des Verstärkers 1 liegenden Phasenschieber 5
optimal addiert. Damit im ersten Kompensationszweig nicht
die doppelte Amplitude zur Wirkung kommt, wird automatisch immer das erste Kompensationssignal vom Verstärker 1 kommend mittels Sperrdiode 7 gesperrt, und zwar
automatisch so lange, wie der Verstärker 2 in Betrieb ist.

Mit dem Buchstaben T sind in der Schaltungsanordnung
Hohlleiterverzweigungen bezeichnet und deren Abschlußwiderstände mit dem Bezugszeichen 9 versehen. Eine derartige Hohlleiterverzweigung wird auch magisches T genannt.

3 Patentansprüche
1 Figur

## Patentansprüche

1. Verfahren zur Beseitigung der Verzerrungen von Verstärkern, bei dem die Differenz zwischen einem Teil der Eingangsspannung und der Ausgangsspannung des Verstärkers derart gebildet wird, daß nur die Verzerrungen übrigbleiben, diese Differenzspannung mittels eines zweiten Verstärkers derart verstärkt wird, daß ihre Größe gleich derjenigen der Verzerrungsanteile im Ausgang des ersten Verstärkers ist, und daß dann die Ausgangsspannungen beider Verstärker so zusammengesetzt werden, daß in der Summenspannung die Verzerrungen gegeneinander kompensiert sind, d a d u r c h  g e k e n n z e i c h n e t , daß einem Verstärker (1) eine Eingangsleistung EL und einem Laufzeitausgleichselement (3) die doppelte Eingangsleistung EL zugeführt werden, wobei der Verstärker (1) eine Ausgangsleistung AL mit Verzerrungen abgibt, daß ein Teil dieser Ausgangsleistung AL über Richtkoppler (4) ausgekoppelt und über ein Phasenschieberelement (5) sowie ein Dämpfungselement (6) bei geöffneter Sperrdiode (7) dem aus Laufzeitausgleichselement (3) und Hilfsverstärker (8) bestehenden Zweig amplitudengleich, aber gegenphasig zugeführt wird, und daß einem Parallelzweig mit einem zweiten Verstärker (2) dem Koppelzweig etwas Leistung zum Sperren des Koppelzweiges des Verstärkers (1) entnommen, die Verzerrung kompensiert und dem Ausgangszweig zugeführt wird.

2. Verfahren nach Anspruch 1, d a d u r c h  g e k e n n z e i c h n e t , daß der über Richtkoppler (4) ausgekoppelte Teil der Ausgangsleistung ungefähr 20dB beträgt.

3. Verfahren nach den Ansprüchen 1 oder 2, d a d u r c h  g e k e n n z e i c h n e t , daß zum Abgleich des Systems erstens der Verstärker (1) abgeschaltet und der Verstärker (2) durch den Hilfsverstärker (3) mittels Phasenschieber (5) und Dämpfungsglied (6) bei eingestellter Ausgangsleistung EL kompensiert wird, daß zweitens der Verstärker (2) abgeschaltet und der Verstärker (1) mittels Phasenschieber (5) und Dämpfungsglied (6) identisch kompensiert wird, und daß drittens beide Verstärker (1, 2) eingeschaltet und zur zweifachen Ausgangsleistung AL durch den im Ausgangszweig des Verstärkers (1) liegenden Phasenschieber (5) addiert werden.

Europäisches
Patentamt

**EUROPÄISCHER RECHERCHENBERICHT**

0095758
Nummer der Anmeldung

EP 83 10 5285

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | DE-A-2 656 436 (LICENTIA PATENT-VERWALTUNGS-GMBH) * Figur 2a; Seite 5, Zeilen 22-26 * | 1 | H 03 F 1/32 |
| A,D | DE-C-1 085 194 (DEUTSCHE BUNDESPOST) * Figur 1 * | 1 | |
| A | EP-A-0 031 182 (PHILIPS) * Figur 1; Zusammenfassung * | 1 | |
| A | US-A-3 993 961 (S. NARAYANAN) * Figur 1 * | | |
| A | NTZ ARCHIV, Nr. 1, 1979 H.J. HEUN et al. "Two-stage predistortion - a method to reduce the nonlinearities of microwave power amplifiers"; Seiten 19-23 * Seite 19; Figur 1 * | | |

RECHERCHIERTE
SACHGEBIETE (Int. Cl. 3)

H 03 F 1/32
H 03 F 1/33
H 03 H 7/48

Der vorliegende Recherchenbericht wurde für alle Patentansprüche erstellt.

| Recherchenort | Abschlußdatum der Recherche | Prüfer |
|---|---|---|
| BERLIN | 16-08-1983 | BREUSING J |

KATEGORIE DER GENANNTEN DOKUMENTEN
X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82